# EUROPÄISCHE PATENTSCHRIFT

(11) **EP 0 815 711 B1**
(45) Veröffentlichungstag und Bekanntmachung des Hinweises auf die Patenterteilung: **21.10.1998**
(21) Anmeldenummer: 96907369.1
(22) Anmeldetag: 06.03.1996
(51) Int. Cl.: H05K 9/00

(54) **ABGESCHIRMTES GEHÄUSE FÜR HOCHFREQUENZSCHALTUNGEN**
SCREENED HOUSING FOR HIGH-FREQUENCY CIRCUITS
BOITIER BLINDE POUR CIRCUITS HAUTE FREQUENCE

(30) Priorität: 06.03.1995 DE 29503735 U; 16.08.1995 DE 19529977
(43) Veröffentlichungstag der Anmeldung: 07.01.1998
(73) Patentinhaber: Wilhelm Sihn jr. KG., 75223 Niefern-Öschelbronn (DE)
(72) Erfinder: WAIDNER, Frank, D-75210 Keltern (DE); AYDT, Gabriele, D-75223 Niefern-Öschelbronn (DE)
(74) Vertreter: Twelmeier, Ulrich, Dipl.Phys.
(86) Internationale Anmeldenummer: EP9600951
(87) Internationale Veröffentlichungsnummer: WO9628006

(56) Entgegenhaltungen:
- EP-A- 0 695 044
- GB-A- 1 324 560
- US-A- 4 851 609

## Beschreibung

Die Erfindung betrifft ein abgeschirmtes, metallisches oder metallisiertes Gehäuse für Hochfrequenzschaltungen mit den im Oberbegriff des Anspruchs 1 angegebenen Merkmalen. Ein solches Gehäuse ist aus der GB-1,324,560 A bekannt. Das Gehäuse hat einen Boden, vier Seitenwände und einen Deckel. Die Hochfrequenzschaltungen befinden sich in einem solchen Gehäuse üblicherweise auf einer Leiterplatte. Gehäuse, die abzuschirmende Hochfrequenzschaltungen aufnehmen, bestehen deshalb üblicherweise aus Metall oder sind metallisiert und werden geerdet. Mit einer lückenhaften Schirmung hat man gclegentlich bei Gehäusen zu kämpfen, die einen abnehmbaren Deckel haben. Zwischen dem Dekkel und den Seitenwänden des Gehäuses besteht ein Spalt, der hochfrequenzmässig undicht sein kann. insbescndere bei preiswerten Gehäusen, bei denen der Spalt schon aus Kostengründen nicht vollständig geschlossen werden kann. Zur Verbesserung der Abschirmung hat das bekannte Gehäuse auf der Innenseite des Deckel und des Bodens jeweils eine blattförmige Kontaktfeder, welche den Boden und den Deckel vollflächig abdeckt und an ihren Rändem abgewinkelte Zungen hat, welche bei zusammengebautem Gehäuse den Seitenwänden anliegen.

Der vorliegenden Erfindung liegt die Aufgabe zugrunde, aufzuzeigen, wie man zu preiswerten und dennoch in hohem Maße hochfrequenzmässig dichten Gehäusen kommen kann.

Diese Aufgabe wird gelöst durch ein Gehäuse mit den im Anspruch 1 angegebenen Merkmalen. Vorteilhafte Weiterbildungen der Erfindung sind Gegenstand der abhängigen Ansprüche.

Erfindungsgemäß wird das Schirmungsmaß dadurch verbessert, daß auf der Innenseite der Seitenwände Metallbänder angeordnet sind, von welchen am oberen Rand Finger abgewinkelt sind, welche federnd am Deckel anliegen. Diese Finger stellen über eine Anzahl von Kontaktpunkten eine zuverlässige elektrische Verbindung zwischen den Seitenwänden und dem Deckel her. Die dadurch verbesserte Schirmung ist um so besser, je dichter die Folge der Finger ist, welche mit dem Deckel Kontakt machen. Deshalb sind die Finger am besten längs aller vier Seitenwände in dichter Folge angeordnet, wobei eine Häufigkeit von zwei bis vier Fingern pro laufendem Zentimeter besonders geeignet ist. Besonders dicht wird das Gehäuse an dieser Stelle, wenn das Band selbst noch längs eines schmalen Streifens durchgehend abgewinkelt ist und die Finger auf diesem abgewinkelten Streifen fußen.

Solche die Schirmung verbessemde Federbänder lassen sich sehr preiswert durch einen Stanz-Biege-Vorgang aus einem geeignetem Federwerkstoff herstellen, z.B. aus CuSn oder aus Kupfer-Beryllium oder aus einem Messing.

Wegen der wesentlichen Verbesserung der Schirmung, die solche Federbänder bringen, ist es möglich, den Gehäuseaufbau weiter zu vereinfachen. Das Gehäuse muß keineswegs mehr aus einem einstückig gegossenen Unterteil mit Bodenplatte und vier Seitenwänden bestehen, vielmehr kann es aufgetrennt werden in eine getrennte Bodenplatte, vier getrennte Seitenwände und einen getrennten Deckel. Die gewünschte HF-Dichtigkeit am Spalt zwischen der Bodenplatte und den Seitenwänden erreicht man auf die gleiche Weise wie am Spalt zwischen den Seitenwänden und dem Deckel, indem man auch längs des unteren Randes der an den Seitenflächen anliegenden Metallbänder Finger vorsieht, welche federnd an der Bodenplatte anliegen. Eine Ausbildung der Federbänder mit abgewinkelten Fingern sowohl am oberen Rand als auch am unteren Rand macht die Federbänder sehr leicht handhabbar; man muß keine besonderen Maßnahmen zu ihrer Fixierung ergreifen. Dadurch, daß die Finger sowohl am Deckel als auch an der Bodenplatte anliegen, werden die Bänder zwischen Deckel und Bodenplatte ohne weiteres eingespannt, wenn das Gehäuse geschlossen wird. Man muß dann lediglich noch dafür sorgen, daß die Federbänder guten Kontakt zu den Seitenwänden haben. Dieser Kontakt wird einerseits dadurch begünstigt, daß die Federbänder den Seitenwänden flächig aufliegen und kann weiterhin dadurch verbessert werden, daß die Seitenwände auf ihrer Innenseite Vorsprünge haben, auf welche die Metallbänder mittels entsprechend angeordneter Positionierlöcher aufgesteckt sind. Ein guter Kontakt der Metallbänder zu den Seitenwänden kann ferner dadurch begünstigt werden, daß die vom Gehäuse aufzunehmende Leiterplatte als Mittel, um die Metallbänder an die Seitenwände anzudrücken, eingesetzt wird. Zu diesem Zweck können aus den Bändern Zungen ausgeschnitten und abgebogen sein, welche dem Rand der Leiterplatte anliegen, wodurch die Metallbänder federnd an die Seitenwände gedrückt werden. Eine andere günstige Möglichkeit besteht darin, Zungen paarweise aus den Bändern auszuschneiden und zur Bildung von gabelförmigen Kontaktklemmen abzubiegen, welche dazu bestimmt sind, mit der Leiterplatte oder mit Bauelementen, welche auf der Leiterplatte angeordnet sind, Kontakt zu machen. Vorzugsweise sind die gabelförmigen Kontaktklemmen oder eine Gruppe von ihnen in einer gemeinsamen, zur Bodenplatte parallelen Ebene angeordnet, nämlich in jener Ebene, in welcher auch die Leiterplatte vorgesehen ist. Die Leiterplatte kann dann an einem oder mehreren, vorzugsweise an allen vier Rändern in solche Federklemmen eingeschoben werden, und zwar nicht nur, um sie mechanisch zu halten, sondern vor allem auch, um sie zuverlässig zu erden. Dadurch, daß am Umfang der Leiterplatte verteilt mehrere solche Kontaktklemmen vorgesehen sind, ist eine zuverlässige Erdung der Leiterplatte auch ohne Lötverbindung möglich, was die Montage der Leiterplatte mit der Hochfrequenzschaltung im Gehäuse erleichtert und verbilligt.

In einer anderen Gruppe von gabelförmigen Kontaktelementen können die Zungen derart ausgeschnitten und abgebogen sein, daß sie sich senkrecht zwischen Bodenplatte und Deckel erstreckende Einführschlitze bilden, also Einführschlitze, die senkrecht zur Ebene der Leiterplatte verlaufen und dazu dienen, irgendwelche Bauteile auf der Leiterplatte zu erden.

Elektrische Anschlüsse, die in das Gehäuse hineinführen, können auf einer oder mehreren der vier Seitenwände oder auch am Gehäuseboden oder am Gehäusedeckel angeordnet sein. Vorzugsweise sieht man die Anschlüsse an einer oder mehrerer der Seitenwände vor, wobei an den Stellen, wo sich die Anschlüsse befinden, die Metallbänder ein Loch haben. Bei den Anschlüssen handelt es sich zumeistens um Steckverbinder. In diesem Fall sind die Steckergehäuse vorzugsweise einstückig mit der Seitenwand gegossen. Im Steckergehäuse sieht man dabei vorzugsweise einen Stützkörper aus elektrisch isolierendem Werkstoff vor, welcher eine an beiden Enden gabelförmig ausgebildete Innenleiterkontaktfeder trägt, welche an ihrem nach außen weisenden Ende den Innenleiter eines koaxialen HF-Steckers aufnimmt und mit ihrem in das Gehäuse gerichteten Ende direkt und ohne Lötverbindung auf einen Anschlußkontakt an der Leiterplatte gesteckt werden kann. Eine dafür geeignete Innenleiterkontaktfeder kann in der Abwicklung H-förmig sein, wobei der Quersteg des H im Stützkörper festgelegt ist. Man kommt auf diese Weise zu einem herstellungstechnisch und montagetechnisch sehr günstigen Gehäusestecker (F-Connector). Damit die Fügespalte zwischen den einzelnen Seitenwänden des Gehäuses hochfrequenzmässig möglichst dicht sind, sind sie vorzugsweise auf Gehrung geschnitten und miteinander verstiftet. Zu diesem Zweck greifen sie auf der Gehäuseinnenseite zweckmäßig scharnierartig ineinander, wobei der durch die Verstiftung bedingte Eingriff den Fügespalt zusätzlich abschirmt. Bodenplatte und Deckel können gegeneinander verspannt werden. Besonders günstig für eine hochfrequenzdichte Gehäuseausbildung ist es allerdings, wenn sowohl der Deckel als auch die Bodenplatte abgewinkelte, die Seitenwände des Gehäuses übergreifende Randteile haben. Sieht man solche Randteile vor, eröffnet sich leicht die Möglichkeit, die Bodenplatte und den Deckel mit den Seitenwänden zu verrasten, z.B. dadurch, daß die Randteile an der Innenseite mit Vorsprüngen versehen sind, die in dazu passende Ausnehmungen auf der Außenseite der Seitenwände einrasten.

Die Erfindung erlaubt einen einfachen, modularen und preiswerten Gehäuseaufbau. Aus wenigen Grundelementen (eine Bodenplatte, ein Deckel, eine Seitenwand ohne Anschlüsse und Seitenwände mit unterschiedlichen Anzahlen von Anschlüssen) läßt sich eine große Vielfalt von unterschiedlichen Gehäusen aufbauen, die trotz zahlreicher Fügespalte hochfrequenzmässig außerordentlich dicht sind und mit gutem Erfolg bis zu Frequenzen von mindestens 2 GHz verwendet werden können und damit vor allem für Gemeinschaftsantennenanlagen, Satellitenempfangsanlagen und Kabelfernsehnetze interessant sind.

Ein Ausführungsbeispiel der Erfindung ist in den beigefügten Zeichnungen dargestellt und wird nachfolgend beschrieben.
- Figur 1: zeigt einen Gehäuseaufbau in Draufsicht bei abgenommenem Dekkel in einer Explosionsdarstellung, und
- Figur 2: zeigt den Vertikalschnitt II-II durch die Darstellung in Figur 1.

Das Gehäuse hat eine Bodenplatte 1 mit vier hochstehenden Randstreifen 2, vier Seitenwänden 3, 4, 5 und 6 sowie einen Deckel 7 mit vier nach unten ragenden Randstreifen 8. Die Bodenplatte 1 und der Deckel 7 sind gleich ausgebildet. In die Seitenwand 3 sind zwei Steckergehäuse 9 integriert, in die Seitenwände 4 und 6 sind jeweils 5 Steckergehäuse 9 integriert. Die Seitenwand 5 hat keine Steckanschlüsse. Die Steckergehäuse 9 sind in einem Stück mit den Seitenwänden 3, 4 und 6 gegossen. In die Steckergehäuse 9 ist jeweils ein Stützkörper 10 aus elektrisch isolierendem Werkstoff eingefügt, welcher eine Kontaktfeder 11 trägt, welche an beiden Enden, sowohl am nach außen weisenden Ende als auch am nach innen weisenden Ende, gabelförmig ausgebildet ist. Diese Kontaktfeder 11 ist ein Stanz-Biegeteil, welches in der ebenen Abwicklung im wesentlichen H-förmig ist; die beiden zueinander parallelen Schenkel des H bilden die beiden Kontaktgabeln, welche durch den Mittelsteg 11a des H verbunden sind, welcher im Stützkörper 10 festgelegt ist.

Die Seitenwände 3 bis 6 werden wechselseitig miteinander verstiftet. Zu diesem Zweck hat jede Seitenwand auf ihrer Innenseite am einen Ende einen oberen Ansatz 12 und einen unteren Ansatz 13 und am gegenüberliegenden Ende einen dazwischen passenden mittleren Ansatz 14. Die Ansätze 12 bis 14 sind fluchtend durchbohrt, so daß sie, nachdem sie wechselseitig zusammengefügt sind, durch Einpressen von vier Stiften (ein Stift an jeder Ecke des Gehäuses) miteinander fest verbunden werden können. Angrenzend an die Ansätze 12 bis 14 sind die Seitenwände 3 bis 6 auf Gehrung 15 geschnitten, was äußerst enge Fügespalte an den vertikalen Gehäusekanten ermöglicht, die obendrein durch die zusammengefügten Ansätze 12 bis 14 und die darin steckenden Stifte abgeschirmt werden.

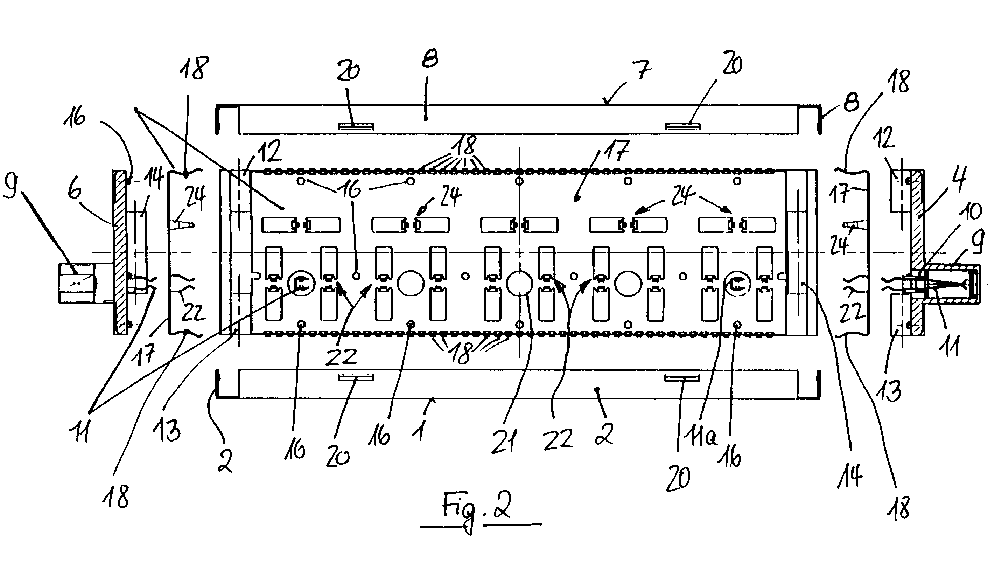

Auf den Innenseiten der Seitenwände 3 bis 6 befinden sich mehrere Vorsprünge 16, z.B. kurze Zapfen, auf welche Metallbänder 17 aufgesteckt sind, welche zu diesem Zweck dazu passende Löcher haben. Die Metallbänder 17 erstrecken sich praktisch über die gesamte Länge und Höhe der Seitenwände 3 bis 6 und sind am oberen und unteren Rand annähemd rechtwinklig abgewinkelt, so daß sie in das Gehäuseinnere weisen. Ihr dadurch gebildeter Randstreifen ist gefiedert; er besteht aus einer Vielzahl von Zungen 18, die in dichter Folge angeordnet sind und auf einem schmalen, noch nicht gefiederten, abgewinkelten Streifen 19 fußen. Wie Figur 2 zeigt, sind die Zungen 18 so gebogen, daß sie sowohl über den unteren als auch über den oberen Rand der Seitenwände 3 bis 6 hinausragen. Das hat zur Folge, daß sich die Zungen 18 federnd an den Deckel 7 und an die Bodenplatte 1 anlegen, wenn diese mit den Seitenwänden 3 bis 6 verbunden werden, um das Gehäuse zu schließen. Die Bodenplatte 1 und der Deckel 7 können mit den Seitenwänden verschraubt oder gegeneinander verspannt werden. Im gezeichneten Ausführungsbeispiel sind sie mit den Seitenwänden verrastet. Zu diesem Zweck haben sie an der Innenseite ihrer Seitenstreifen 2 und 8 Vorsprünge 20, welche in dazu passende Ausnehmungen auf der Außenseite der Seitenwände 3 bis 6 einrasten. Natürlich muß die Verrastung so fest sein, daß sie die von den Zungen 18 ausgeübten Druckkräfte auffangen kann. Die Metallbänder 17 schirmen die Fügespalte zwischen den Seitenwänden 3 bis 7 und der Bodenplatte 1 einerseits sowie dem Deckel 7 andererseits ab und sorgen für einen vielfachen, guten Massekontakt zwischen diesen Teilen.

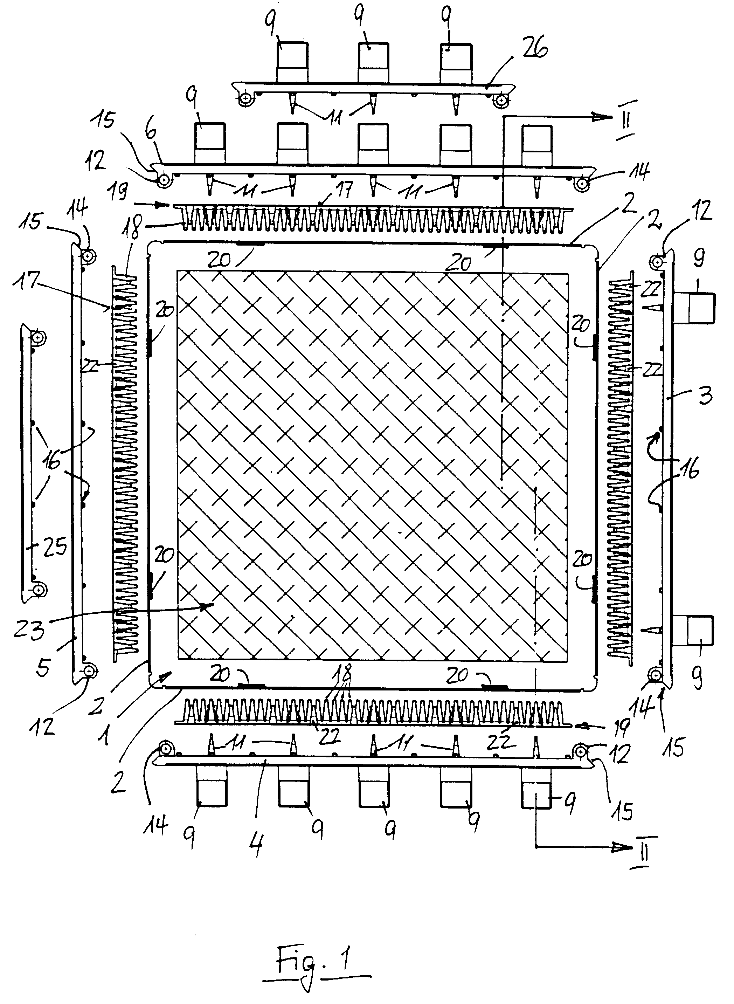

Dort, wo an den Seitenwänden 3, 4 und 6 die Gehäusestecker 9 vorgesehen sind, haben die Metallbänder 17 Ausnehmungen 21, welche den ungehinderten Durchtritt der Kontaktklemmen 11 ermöglichen. Dabei genügt es, für die unterschiedlichen Seitenwände 3 bis 6 eine Ausführungsform des Metallbandes 17 vorzusehen, welche - im gezeichneten Ausführungsbeispiel - fünf solcher Ausnehmungen 21 hat und damit für Seitenwände mit 0 bis 5 Gehäusesteckern paßt. Im Bereich zwischen den Ausnehmungen 21 sind Paare 22 von fedemden Zungen ausgeschnitten, ungefähr rechtwinklig aus dem Band 17 herausgebogen und so profiliert, daß dadurch Kontaktklemmen gebildet werden, welche in einer gemeinsamen Ebene parallel zum Deckel 7 liegen und dazu dienen, eine Leiterplatte 23, deren Lage in Figur 1 angedeutet ist, an allen vier Ränder mehrfach zu kontaktieren, wodurch eine zuverlässige, lötfreie Masseverbindung von der Leiterplatte 23 zum Gehäuse hergestellt wird. Oberhalb der Ausnehmungen 21 sind weitere Paare 24 von Zungen ausgeschnitten und ungefähr rechtwinklig aus der Ebene des Metallbandes 17 einwärts gebogen, wodurch weitere gabelförmige Kontaktklemmen gebildet werden, deren Einführschlitz aber im Gegensatz zu den Kontaktklemmen 22 um 90° verdreht orientiert ist und von oben nach unten verläuft. Die Kontaktklemmen 24 dienen zur Massekontaktgabe an Bauteilen auf der Leiterplatte 23.

Mit den dargestellten Bauelementen kann eine Vielzahl von unterschiedlichen, im Grundriß quadratischen Gehäusen gebildet werden. Mit zwei weiteren Typen von kürzeren Seitenwänden 25 und 26 und dazu passenden kleineren quadratischen, untereinander gleichen Deckeln und Bodenplatten lassen sich weitere gleichartige Gehäuse bilden. In Kombination mit rechteckigen Bodenplatten und Deckeln, deren Kantenlängen den Längen der Seitenteile 3 bis 6 und 25 und 26 gleich sind, lassen sich mit diesen Teilen darüber hinaus zahlreiche weitere Gehäusevarianten in Modulbauweise zusammenbauen. Besonders geeignete Längenverhältnisse der Seitenwände sind 1:2 und 2:3.

Auf die Steckergehäuse 9 können einzelne Stecker aufgesteckt werden, aber auch komplette Geräte mit einer entsprechenden Anzahl von Gegensteckern.

## Patentansprüche

1. Abgeschirmtes metallisches oder metallisiertes Gehäuse für Hochfrequenzschaltungen auf einer Leiterplatte (23)
mit einem Boden (1), mit vier Seitenwänden (3, 4, 5, 6) und mit einem abnehmbaren Deckel (7), und mit einem auf der Innenseite des Gehäuses vorgesehenen Metallband (17), von dessen Rand Finger (18) abgewinkelt sind, welche fedemd an der Innenseite des Gehäuses anliegen,
**dadurch gekennzeichnet,** daß auf der Innenseite der Seitenwände (3, 4, 5, 6) jeweils ein solches Metallband (17) angeordnet ist, von welchem die Finger (18) am oberen Rand abgewinkelt sind und federnd am Deckel (7) anliegen,
und daß aus den Bändern Zungen ausgeschnitten und abgebogen sind, welche dazu bestimmt sind, dem Rand der Leiterplatte (23) anzuliegen.

2. Gehäuse nach Anspruch 1, **dadurch gekennzeichnet,** daß auch der Boden (1) abnehmbar ist und von den Bändern (17) auch am unteren Rand Finger (18) abgewinkelt sind, welche fedemd an der Bodenplatte (1) anliegen.

3. Gehäuse nach Anspruch 1 oder 2, **dadurch gekennzeichnet,** daß zwischen oberem und unterem Rand Paare (22, 24) vcn Zungen ausgestanzt und zur Bildung von gabelförmigen Kontaktklemmen abgebogen sind.

4. Gehäuse nach Anspruch 3, **dadurch gekennzeichnet,** daß die gabelförmigen Kontaktklemmen (22) oder eine Gruppe von ihnen in einer gemeinsamen zur Bodenplatte (1) parallelen Ebene angeordnet sind.

5. Gehäuse nach Anspruch 4, **dadurch gekennzeichnet,** daß in einer anderen Gruppe der gabelförmigen Kontaktklemmen (24) die Zungen derart ausgeschnitten und abgebogen sind, daß sie sich senkrecht zwischen Bodenplatte (1) und Decke (7) erstreckende Einführschlitze bilden.

6. Gehäuse nach einem der vorstehenden Ansprüche, **dadurch gekennzeichnet,** daß an wenigstens einer der Seitenwände (3, 4, 6) sich nach außen erstreckende Steckergehäuse (9) vorgesehen sind und daß das auf der Innenseite der Seitenwand angeordnete Metallband (17) an dieser Stelle ein Loch (21) hat.

7. Gehäuse nach Anspruch 6, **dadurch gekennzeichnet,** daß das Steckergehäuse (9) einstückig mit der Seitenwand (3, 4, 6) gegossen ist.

8. Gehäuse nach Anspruch 6 oder 7, **dadurch gekennzeichnet,** daß in das Steckergehäuse (9) ein Stützkörper (10) aus elektrisch isolierendem Werkstoff eingesetzt ist, welcher eine an beiden Enden gabelförmig ausgebildete Innenleiterkontaktfeder (11) trägt.

9. Gehäuse nach Anspruch 8, **dadurch gekennzeichnet,** daß die Innenleiter-Kontaktfeder (11) in der Abwicklung H-förmig ist, wobei der Quersteg (11a) des H im Stützkörper (10) festgelegt ist.

10. Gehäuse nach einem der vorstehenden Ansprüche, **dadurch gekennzeichnet,** daß die Seitenwände (3, 4, 5, 6) auf ihrer Innenseite Vorsprünge (16) haben, auf welche die Metallbänder (17) mittels entsprechend angeordneter Positionierlöcher aufgesteckt sind.

11. Gehäuse nach einem der vorstehenden Ansprüche, **dadurch gekennzeichnet,** daß die Seitenwände (3, 4, 5, 6) zueinander auf Gehrung geschnitten und miteinander verstiftet sind.

12. Gehäuse nach einem der vorstehenden Ansprüche, **dadurch gekennzeichnet,** daß der Deckel (7) und die Bodenplatte (1) abgewinkelte, die Seitenwände (3, 4, 5, 6) übergreifende Randteile (2, 8) haben.

13. Gehäuse nach Anspruch 12, **dadurch gekennzeichnet,** daß die Randteile (2, 8) mit Vorsprüngen (20) in dazu passende Ausnehmungen der Seitenwände (3, 4, 5, 6) rasten.

14. Gehäuse nach einem der vorstehenden Ansprüche, **dadurch gekennzeichnet,** daß die Finger (18) in dichter Folge angeordnet sind.

15. Gehäuse nach Anspruch 14, **dadurch gekennzeichnet,** daß 2 bis 4 Finger (18) pro lfd. Zentimeter des Randes des Metallbandes (17) vorgesehen sind.

## Claims

1. A shielded metal or metal-plated housing for high-frequency circuits on a printed circuit board (23),
having a base (1), four side walls (3, 4, 5, 6) and a removable cover (7), and having a metal strip (17) provided on the inside of the housing, from the edge of which fingers (18) are bent away and abut resiliently against the inside of the housing,
characterized in that, arranged on the inside of each side wall (3, 4, 5, 6), there is such a metal strip (17) from which the fingers (18) are bent away at the upper edge and abut resiliently against the cover (7), and in that tongues are cut out of the strips and bent away, said tongues being intended to abut against the edge of the printed circuit board (23).

2. A housing according to Claim 1, characterized in that the base (1) is also removable and fingers (18) are also bent away from the strips (17) at the lower edge and abut resiliently against the base plate (1).

3. A housing according to Claim 1 or 2, characterized in that pairs (22, 24) of tongues are punched out between the upper and lower edge and are bent away to form fork-shaped contact clips.

4. A housing according to Claim 3, characterized in that the fork-shaped contact clips (22), or a group thereof, are arranged in a common plane which is parallel to the base plate (1).

5. A housing according to Claim 4, characterized in that in another group of the fork-shaped contact clips (24) the tongues are cut out and bent away such that they form entry slots extending perpendicularly between the base plate (1) and the cover (7).

6. A housing according to one of the preceding claims, characterized in that outwardly extending connector housings (9) are provided on at least one of the side walls (3, 4, 6), and in that the metal strip (17) arranged on the inside of the side wall has a hole (21) at this point.

7. A housing according to Claim 6, characterized in that the connector housing (9) is cast in one piece with the side wall (3, 4, 6).

8. A housing according to Claim 6 or 7, characterized in that a supporting body (10) of electrically insulating material is inserted into the connector housing (9) and supports an inner-conductor contact spring (11) which is of a fork-shaped construction at both ends.

9. A housing according to Claim 8, characterized in that the inner-conductor contact spring (11) is in an H shape as seen laid flat, the transverse web (11a) of the H being positioned in the supporting body (10).

10. A housing according to one of the preceding claims, characterized in that the side walls (3, 4, 5, 6) have projections (16) on their inside, onto which the metal strips (17) are pushed by means of correspondingly arranged positioning holes.

11. A housing according to one of the preceding claims, characterized in that the side walls (3, 4, 5, 6) are cut so that they are bevelled with respect to one another and pinned together.

12. A housing according to one of the preceding claims, characterized in that the cover (7) and the base plate (1) have edge parts (2, 8) which are bent away and reach over the side walls (3, 4, 5, 6).

13. A housing according to Claim 12, characterized in that projections (20) on the edge parts (2, 8) latch into matching cutouts in the side walls (3, 4, 5, 6).

14. A housing according to one of the preceding claims, characterized in that the fingers (18) are arranged one closely following another.

15. A housing according to Claim 14, characterized in that 2 to 4 fingers (18) are provided per centimetre along the edge of the metal strip (17).

## Revendications

1. Boîtier métallique ou métallisé fermé, destiné à recevoir des circuits à haute fréquence montés sur des plaquettes de circuits imprimés (23), comprenant un fond (1), quatre parois latérales (3, 4, 5, 6) et un couvercle (7) amovible, ainsi qu'une bande métallique (17) prévue sur la face intérieure du boîtier, sur le bord de laquelle bande sont repliés des tétons (18), qui entrent en contact élastique avec la face intérieure du boîtier, caractérisé en ce que, sur la face intérieure de chaque paroi latérale (3, 4, 5, 6), est posée une bande métallique (17) de ce type, sur laquelle les tétons (18) sont repliés sur le bord supérieur et entrent en contact élastique avec le couvercle (7) et en ce que des languettes sont découpées dans les bandes puis coudées, lesquelles languettes sont destinées à être repliées contre le bord de la plaquette à circuits imprimés (23).

2. Boîtier selon la revendication 1, caractérisé en ce que le fond (1) est également amovible et des tétons (18) sont repliés également sur le bord inférieur des bandes (17), lesquels tétons entrent en contact élastique avec le fond (1).

3. Boîtier selon la revendication 1 ou 2, caractérisé en ce que des paires (22, 24) de languettes sont découpées entre le bord supérieur et le bord inférieur et sont repliées pour former des bornes de contact fourchues.

4. Boîtier selon la revendication 3, caractérisé en ce que les bornes de contact (22) fourchues ou un groupe de celles-ci sont disposés dans un même plan parallèle au fond (1).

5. Boîtier selon la revendication 4, caractérisé en ce que dans un autre groupe de bornes de contact (24) fourchues, les languettes sont découpées et pliées de telle sorte qu'elles forment des fentes de passage qui s'étendent perpendiculairement entre le fond (1) et le couvercle (7).

6. Boîtier selon l'une quelconque des revendications précédentes, caractérisé en ce que, sur au moins une des parois latérales (3, 4, 6) sont prévus des logements de prise (9) qui s'avancent vers l'extérieur et en ce qu'un trou (21) est réalisé dans cette zone dans la bande métallique (17) disposée sur la face intérieure de la paroi latérale.

7. Boîtier selon la revendication 6, caractérisé en ce que le logement de prise (9) est moulé d'une seule pièce avec la paroi latérale (3, 4, 6).

8. Boîtier selon la revendication 6 ou 7, caractérisé en ce qu'un corps de support (10), réalisé dans un matériau permettant l'isolement électrique, est inséré dans le logement de prise (9), lequel corps de support porte un ressort de contact pour conducteur interne (11), dont les deux extrémités sont fourchues.

9. Boîtier selon la revendication 8, caractérisé en ce que le ressort de contact pour conducteur interne (11) se déploie en forme de H, la branche transversale (11a) du H étant fixée dans le corps de support (10).

10. Boîtier selon l'une quelconque des revendications précédentes, caractérisé en ce que la face intérieure des parois latérales (3, 4, 5, 6) est munie de saillies (16), sur lesquelles sont posées les bandes métalliques (17) par l'intermédiaire de trous de positionnement disposés de manière correspondante.

11. Boîtier selon l'une quelconque des revendications précédentes, caractérisé en ce que les parois latérales (3, 4, 5, 6) sont assemblées en onglets fixés par des goupilles.

12. Boîtier selon l'une quelconque des revendications précédentes, caractérisé en ce que le couvercle (7) et le fond (1) sont munis de bords (2, 8) coudés qui s'engagent au-dessus des parois latérales (3, 4, 5, 6).

13. Boîtier selon la revendication 12, caractérisé en ce que les bords (2, 8) sont munis de saillies (20) qui s'encastrent dans des évidements correspondants réalisés dans les parois latérales (3, 4, 5, 6).

14. Boîtier selon l'une quelconque des revendications précédentes, caractérisé en ce que les tétons (18) forment une succession rapprochée de tétons.

15. Boîtier selon la revendication 14, caractérisé en ce qu'il est prévu de réaliser 2 à 4 tétons (18) par centimètre sur le bord de la bande métallique (17).
